# EUROPEAN PATENT APPLICATION

(11) **EP 4 071 798 A1**
(43) Date of publication of application: **12.10.2022**
(21) Application number: 22165134.2
(22) Date of filing: 29.03.2022
(51) Int. Cl.: H01L 23/40

(54) **SNAP FIT HEATSINK LUG**

(30) Priority: 31.03.2021 KR 20210042336
(71) Applicant: Hansol Technics Inc., Seoul 04551 (KR)
(72) Inventor: LEE, Ju Hyun, 27850 Jincheon-gun, Chungcheongbuk-do (KR); JIN, Ho Seong, 27850 Jincheon-gun, Chungcheongbuk-do (KR); HAN, Chul Hee, 27850 Jincheon-gun, Chungcheongbuk-do (KR); HYUN, Insu, 27850 Jincheon-gun, Chungcheongbuk-do (KR)
(74) Representative: Jordan, Volker Otto Wilhelm

(57) **Abstract**

Provided is a snap fit heatsink lug configured to be fixed without soldering, and in case of soldering, configured to be soldered without swell or distortion. The snap fit heatsink lug includes a lug base where a heatsink is configured to be mounted on a top thereof, and a lug fixator provided at two ends of the lug base to fix the lug base to a printed circuit board, wherein the lug fixator includes a lug fixator base and a fixing pin which protrudes downward from a bottom of the lug fixator base and is inserted into the printed circuit board, the fixing pin includes a first fixing pin and a second fixing pin, and at least one of the first fixing pin or the second fixing pin has a stopper at an exposed location below the printed circuit board when inserted into the printed circuit board.

## Description

### CROSS-REFERENCE TO RELATED APPLICATION

This application claims priority to Korean Patent Application No. 10-2021-0042336, filed on March 31, 2021, and all the benefits accruing therefrom under 35 U.S.C. §119, the contents of which in its entirety are herein incorporated by reference.

### BACKGROUND

### 1. Field

The present disclosure relates to a heatsink lug, and more particularly, to a snap fit heatsink lug configured to be fixed to a printed circuit board by snap fit without soldering, and in case of soldering, configured to be soldered without swell or distortion.

### 2. Description of the Related Art

A heatsink, one of components which are attached to a printed circuit board (PCB), is designed to easily dissipate heat generated by the operation of other electronic components attached to the printed circuit board, thereby preventing overheat.

The heatsink is mounted on a heatsink lug, and the heatsink lug is fixed to the printed circuit board, and thus the heatsink is mounted on the printed circuit board, and in general, the heatsink lug is mounted by inserting an insert pin formed at the lower part into an insert hole of the printed circuit board, and is fixed by soldering an exposed part of the insert pin below the printed circuit board.

However, since there is an allowance between the insert pin and the insert hole, with which the insert pin is inserted into the insert hole in the process of mounting the heatsink lug, the heatsink lug is mounted by loose fitting, and this causes swelling or distortion during the soldering process.

By this reason, intermediate fit or interference fit may be performed with the minimum allowance of the insert pin for the insert hole, but in this case, it is not easy to assemble, so the assembly process time increases, and in some instances, the printed circuit board may be damaged.

Meanwhile, the soldering method has an inconvenience of having to periodically inspect the soldering due to a gradual decrease in bond strength by repeated thermal expansion and contraction of the heatsink and external impacts, and requires material costs for fixation.

### SUMMARY

The present disclosure is designed to solve the above-described problem, and therefore the present disclosure is directed to providing a snap fit heatsink lug with an improved structure of a fixing pin which is inserted into a printed circuit board (PCB) so that the heatsink lug can be mounted on the printed circuit board by loose fitting and fixed without soldering, and in case of soldering, can be tightly fixed to the printed circuit board by soldering without swell or distortion.

A snap fit heatsink lug according to an embodiment of the present disclosure for solving the above-described problem includes a lug base configured to have a heatsink mounted on a top thereof, and a lug fixator provided at two ends of the lug base and configured to fix the lug base to a printed circuit board, wherein the lug fixator includes a lug fixator base and a fixing pin protruding downward from a bottom of the lug fixator base and configured to be inserted into the printed circuit board, and wherein the fixing pin a first fixing pin and a second fixing pin, and at least one of the first fixing pin or the second fixing pin has a stopper at an exposed location below the printed circuit board when the fixing pin is inserted into the printed circuit board.

Here, the lug fixator may further include a lug fixator insert piece protruding from a top of the lug fixator base toward a direction of the lug base and is insertable into the lug base, and wherein the lug fixator may be attachable to and detachable from the lug base.

Additionally, the first fixing pin may be connected to a first extension piece extending downward from the lug fixator base, the second fixing pin may be connected to a second extension piece extending downward from the lug fixator base and spaced apart from a side of the first extension piece, each of the first and second fixing pins may have a shape of a right angle, such as '¬', and extend from each extension piece such that corner surfaces face each other inwards, and a clearance hole may be formed between the first and second extension pieces and the first and second fixing pins.

Additionally, one of the first extension piece and the second extension piece may have an inclined inner surface and the clearance hole may have a trapezoidal shape.

Additionally, the first extension piece may protrude from an extended location of the first fixing pin to form a first support which is configured to be seated on an upper surface of the printed circuit board, and the second extension piece may protrude from an extended location of the second fixing pin to form a second support which is configured to be seated on the upper surface of the printed circuit board.

Additionally, when only one of the first and second fixing pins has a stopper, the fixing pin which does not have the stopper among the first and second fixing pins may have a decreasing width toward a insertion direction of the fixing pin.

Additionally, the stopper may include a first inclined portion which is inclined downward in an outward direction from the fixing pin and a second inclined portion which is formed with a longer length than the first inclined portion from the first inclined portion and is inclined downward to an end of the fixing pin.

Additionally, the stopper may further include a triangular protrusion on the first inclined portion, and the triangular protrusion may protrude to a protruding length that is equal to or smaller than a protruding length of a protruding end formed by an extended part of the first inclined portion and the second inclined portion.

Additionally, the second inclined portion may include a multistep pointed protrusion along a length.

Meanwhile, the stopper may include a third inclined portion which is inclined upward in the outward direction from the fixing pin and a fourth inclined portion which is formed with a longer length than the third inclined portion from the third inclined portion and is inclined downward to the end of the fixing pin, and at least one stopper may be provided.

Additionally, the lug fixator may further include a fixing cap into which the first fixing pin and the second fixing pin exposed below the printed circuit board are inserted together, the fixing cap having a larger diameter than an insert hole of the printed circuit board into which the first fixing pin and the second fixing pin are inserted, and the fixing cap may have bond strength with each fixing pin by the stopper.

Additionally, each of the first and second fixing pins may have a fixing key insert groove on an inner surface at the exposed location below the printed circuit board, and a fixing key which resists in a direction opposite to the insertion direction may be inserted into the fixing key insert groove.

Additionally, the fixing key may have a longer length than a length between the fixing key insert grooves provided in each of the first and second fixing pins.

Additionally, each of the first and second fixing pins may have a deflection resistance protrusion which protrudes between the first fixing pin and the second fixing pin on the inner surface at the exposed location below the printed circuit board, and the deflection resistance protrusion may form a repulsive force outwards when an external force deflecting the fixing pin inwards is applied.

Additionally, at least one of the first fixing pin or the second fixing pin may include a deflection regulator to regulate the extent of deflection of the fixing pin, and the deflection regulator may include a screw protrusion which protrudes between the first fixing pin and the second fixing pin on the inner surface at the exposed location of the fixing pin below the printed circuit board and has a screw thread on an outer surface, and a regulation member which has a screw thread that mate with the screw protrusion on an inner circumferential surface and develops deflection resistance against the fixing pin on the other side while moving along the screw protrusion.

The snap fit heatsink lug according to an embodiment of the present disclosure can be mounted on the printed circuit board by loose fitting, and in case of soldering, can be tightly fixed to the printed circuit board by soldering without swell or distortion, thereby improving the assembly convenience, shortening the assembly process time, and significantly reducing the likelihood that the printed circuit board may be damaged.

Additionally, in case of fixing without soldering, it is possible to shorten the assembly process time, facilitate the maintenance and repair, and reduce the material costs.

Additionally, the effect according to an embodiment of the present disclosure is not limited to the above-described effect, and may further include all predictable effects from the specification and drawings.

### BRIEF DESCRIPTION OF THE DRAWINGS

FIG. 1 is a perspective view showing that a snap fit heatsink lug according to an embodiment of the present disclosure is mounted on a printed circuit board.
FIG. 2 is a diagram when FIG. 1 is viewed from a lug fixator.
FIG. 3 shows a detachable lug fixator of FIG. 1.
FIGS. 4 to 11 are diagrams showing various shapes of a fixing pin of the snap fit heatsink lug of FIG. 1.

### DETAILED DESCRIPTION

Hereinafter, the description of the present disclosure made with reference to the accompanying drawings is not limited to a particular embodiment and a variety of modifications may be made to the present disclosure to present many embodiments. Additionally, it should be understood that the following description includes all modifications, equivalents or substituents included in the spirit and scope of the present disclosure.

In the following description, the terms "first", "second" and the like are used to describe various elements, but not limited thereto, and they are used to distinguish one element from another.

The same reference numeral denotes the same element throughout the specification.

Unless the context clearly indicates otherwise, singular forms include plural forms. Additionally, it should be understood that the term "comprises", "includes" or "have" when used in this specification, specifies the presence of stated features, integers, steps, operations, elements, components or groups thereof but does not preclude the presence or addition of one or more other features, integers, steps, operations, elements, components or groups thereof.

Hereinafter, a snap fit heatsink lug according to an embodiment of the present disclosure will be described in detail with reference to the accompanying drawings.

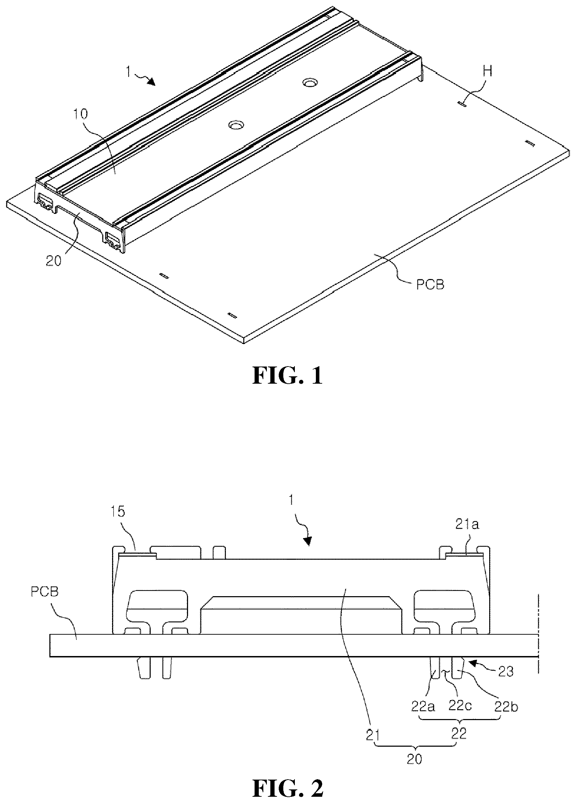

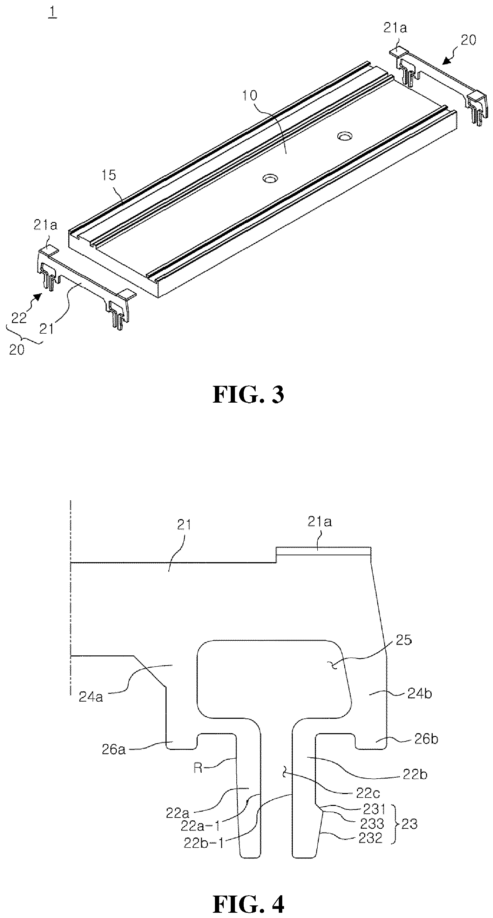

FIG. 1 is a perspective view showing a snap fit heatsink lug according to an embodiment of the present disclosure mounted on a printed circuit board (PCB), FIG. 2 is a diagram when FIG. 1 is viewed from a lug fixator, FIG. 3 shows the detachable lug fixator of FIG. 1, and FIG. 4 is a diagram showing an example of a fixing pin of the snap fit heatsink lug of FIG. 1.

Referring to FIGS. 1 to 4, the snap fit heatsink lug 1 according to an embodiment of the present disclosure may include a lug base 10 where a heatsink (not shown) is mounted on top, and a lug fixator 20 provided at two ends of the length of the lug base 10 to fix the lug base 10 to the printed circuit board PCB.

In this instance, the lug base 10 has at least one mount groove 15 on top to mount the heatsink in such a manner that a portion of the lower part of the heatsink is inserted into the mount groove 15, and the mount groove 15 may be preferably formed with the same length as the length of the lug base 10 to slidably mount the heatsink.

Additionally, the lug fixator 20 may include a lug fixator base 21 having a length that is equal or close to the widthwise length of the lug base 10, and a fixing pin 22 that protrudes downward from the bottom of the lug fixator base 21 and is inserted into the printed circuit board PCB so that a part of the fixing pin 22 is exposed below the printed circuit board PCB.

In this instance, the present disclosure is characterized in that the fixing pin 22 is cut into two sides of an imaginary line on the basis of the insertion direction to form a first fixing pin 22a and a second fixing pin 22b.

That is, as the central part of the fixing pin 22 is cut along the height-wise direction, the first fixing pin 22a and the second fixing pin 22b are spaced apart on the two sides to form a height, and in this instance, due to a cutout 22c provided between the first fixing pin 22a and the second fixing pin 22b, the first fixing pin 22a and the second fixing pin 22b have such an elastic structure that they can deflect inward or expand.

Accordingly, in the deflected state, the first fixing pin 22a and the second fixing pin 22b may be inserted into the printed circuit board PCB, and after inserted, may be restored in the expansion direction and brought into close contact with the printed circuit board and may exert a resistive force to separation.

Meanwhile, the present disclosure may include a stopper 23 in at least one of the first fixing pin 22a or the second fixing pin 22b at the exposed location below the printed circuit board PCB when inserted into the printed circuit board PCB to further improve the separation prevention of the first fixing pin 22a and the second fixing pin 22b.

That is, each of the first fixing pin 22a and the second fixing pin 22b may have the stopper 23, and only one of the first fixing pin 22a and the second fixing pin 22b may have the stopper 23, and here, the stopper 23 provided in the first fixing pin 22a or the second fixing pin 22b may protrude outward from the fixing pin 22 and act as resistance against the printed circuit board PCB when the fixing pin 22 goes upward.

Here, the shape of the stopper 23 may have various structures according to the shape of the fixing pin 22, and the various structures of the fixing pin 22 will be described below with reference to FIGS. 4 to 11.

Meanwhile, the lug fixator 20 may be integrally formed with the lug base 10 and may form a side of the lug base 10, but preferably, the lug fixator 20 may be a separate component from the lug base 10 and may be attachable to or detachable from the lug base 10.

To this end, the lug fixator 20 may further include a lug fixator insert piece 21a that protrudes in the frontward or rearward direction on top of the lug fixator base 21 and is inserted into the lug base.

In case that the mount groove 15 is configured to slidably mount the heatsink (not shown), the lug fixator insert piece 21a may be configured to be inserted into the mount groove 15, but in case that the mount groove 15 is configured to mount the heatsink in the vertical direction, a lug 1 may have a hole or a groove into which the lug fixator insert piece 21a is inserted.

Additionally, the first fixing pin 22a and the second fixing pin 22b may be extended directly from the lug fixator base 21, but preferably, to increase elasticity, a first extension piece 24a and a second extension piece 24b may be further included, and the first fixing pin 22a and the second fixing pin 22b may be extended from the first extension piece 24a and the second extension piece 24b.

Specifically, the first extension piece 24a may be extended downward from the lug fixator base 21, and the second extension piece 24b may be extended downward from the lug fixator base 21, spaced apart from the side of the first extension piece 24a. That is, the first extension piece 24a and the second extension piece 24b are disposed on either side.

In this instance, each of the first fixing pin 22a and the second fixing pin 22b may be formed in the shape of a right angle, such as '¬', and extended from the first extension piece 24a and the second extension piece 24b, respectively. Additionally, the first fixing pin 22a and the second fixing pin 22b may be extended from the extension pieces 24a, 24b such that curved surfaces 22a-1, 22b-1 face each other inwards, respectively.

The first fixing pin 22a and the second fixing pin 22b may form a rectangular clearance hole 25 together with each extension piece 24a, 24b, and accordingly, elasticity is provided by the cutout 22c, but higher elasticity may be provided by the clearance hole 25, which makes it easier and freer to deflect and expand. Additionally, it is possible to prevent load concentration on a specific part and allow for more uniform load.

Meanwhile, when one of the first extension piece 24a and the second extension piece 24b has an inclined inner side, the clearance hole 25 may be formed in a trapezoidal shape. It is possible to improve flexibility since the first fixing pin 22a and the second fixing pin 22b spread in the inclination direction.

Additionally, although not shown in the drawing, when both the first extension piece 24a and the second extension piece 24b are inclined, the clearance hole 25 may be formed in the shape of an isosceles trapezoid.

Meanwhile, the first extension piece 24a may further protrude in the vertical direction at the extended location of the first fixing pin 22a to form a first support 26a which is seated on the upper surface of the printed circuit board PCB when mounting the lug 1, and the second extension piece 24b may further protrude in the vertical direction at the extended location of the second fixing pin 22b to form a second support 26b which is seated on the upper surface of the printed circuit board PCB when mounting the lug.

Here, when the fixing pin is inserted into the printed circuit board PCB, the first and second supports 26a, 26b may prevent the direct contact of the lug with the printed circuit board PCB and form a gap between the lug and the printed circuit board PCB, thereby minimizing friction and forming an air gap.

In this instance, the first and second supports 26a, 26b preferably have their ends at the same height to uniformly support the lug 1.

Furthermore, the fixing pin 22 having no stopper 23 among the first and second fixing pins 22a, 22b may have a curve R on the outer surface such that the width becomes narrower toward the insertion direction. Through this, it may be easier to insert the fixing pin 22.

FIGS. 4 to 11 are diagrams showing various structures of the fixing pin.

To begin with, referring to FIG. 4, the stopper 23 may include a first inclined portion 231 which is inclined downward in the outward direction from the fixing pin 22 and a second inclined portion 232 which is formed with a longer length than the first inclined portion 231 from the first inclined portion 231 and is inclined downward to the end of the fixing pin 22.

In this instance, a protruding end 233 is formed at an extended part of the first inclined portion 231 and the second inclined portion 232, and the protruding end 233 performs a function to stop the printed circuit board PCB, causing resistance to separation.

Here, the protruding end 233 may be pointed as shown in the drawing, but is not necessarily limited thereto, and may be formed in any other shape that is effective in the stopper function.

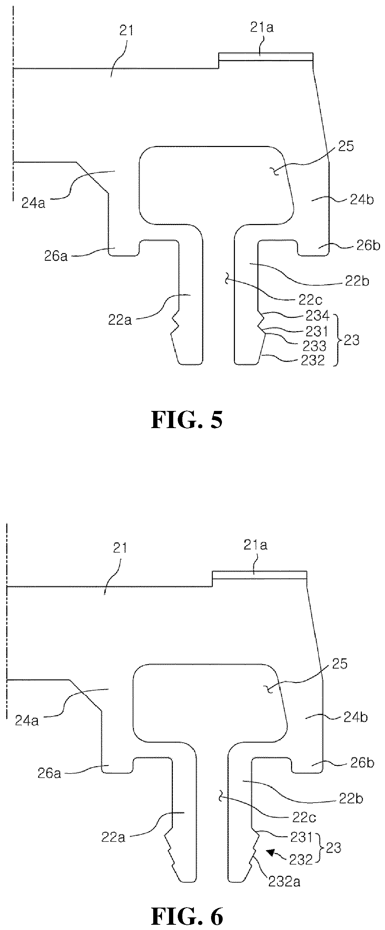

Referring to FIG. 5, the stopper 23 may further include a triangular protrusion 234 on the first inclined portion 231, and the triangular protrusion 234 may protrude to a protruding length that is equal to or smaller than the protruding length of the protruding end 233. The triangular protrusion 234 may prevent separation together with the protruding end 233 of the first inclined portion 231 and the second inclined portion 232, thereby improving the separation prevention of the fixing pin 22.

Referring to FIG. 6, the second inclined portion 232 may include a multistep pointed protrusion 232a along the length. The multistep pointed protrusion 232a may perform a multistep stopper function to prevent the separation of the fixing pin, thereby improving the separation prevention.

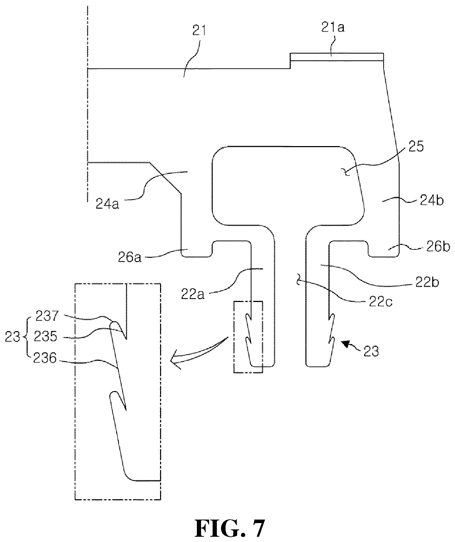

Referring to FIG. 7, in another example, the stopper 23 may include a third inclined portion 235 which is inclined upward in the outward direction from the fixing pin 22 and a fourth inclined portion 236 which is formed with a longer length than the third inclined portion 235 from the third inclined portion 235 and is inclined downward to the end of the fixing pin 22.

Here, an upward pointed end 237 is formed by the extension of the third inclined portion 235 and the fourth inclined portion 236, and the upward pointed end 237 performs a function to stop the printed circuit board PCB, causing resistance to separation.

In this instance, only one stopper 23 including the third inclined portion 235 and the fourth inclined portion 236 may be provided, but a plurality of stoppers 23 may be provided along the height of the fixing pin 22.

That is, at least one third inclined portion 235 and at least one fourth inclined portion 236 may be provided along the height-wise direction, and as the number of third inclined portions 235 and fourth inclined portions 236 increases, the likelihood of separation may decrease.

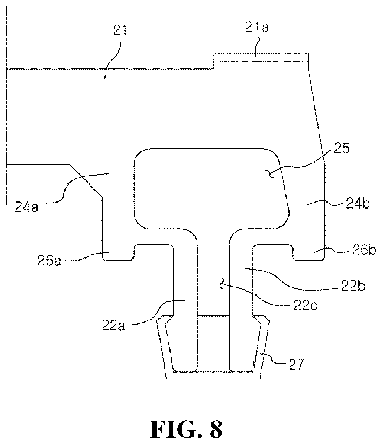

Referring to FIG. 8 which is a cross-sectional view of a fixing cap 27 mounted on the fixing pin 22, the lug fixator 20 may further include the fixing cap 27 which is inserted into the exposed part when the first fixing pin 22a and the second fixing pin 22b are inserted into the printed circuit board PCB, and the fixing cap 27 may have a larger diameter than an insert hole H of the printed circuit board PCB into which the first fixing pin 22a and the second fixing pin 22b are inserted.

Here, when the fixing cap 27 is inserted into the first fixing pin 22a and the second fixing pin 22b, the fixing cap 27 may have bond strength with each fixing pin 22a, 22b by the stopper 23, and to this end, in case that the fixing cap 27 is provided, the stopper 23 is preferably formed in both the first fixing pin 22a and the second fixing pin 22b.

However, the present disclosure is not necessarily limited thereto, and the fixing cap 27 may be mounted even when the stopper 23 is provided in only one of the first fixing pin 22a and the second fixing pin 22b.

The fixing cap 27 has a larger diameter than the insert hole H of the printed circuit board PCB, to resist the separation of the first fixing pin 22a and the second fixing pin 22b in a direction opposite to the insertion direction, thereby preventing the separation.

Additionally, the fixing cap 27 which is attached to the first fixing pin 22a and the second fixing pin 22b can be detached, and the fixing cap 27 may be added or omitted if necessary.

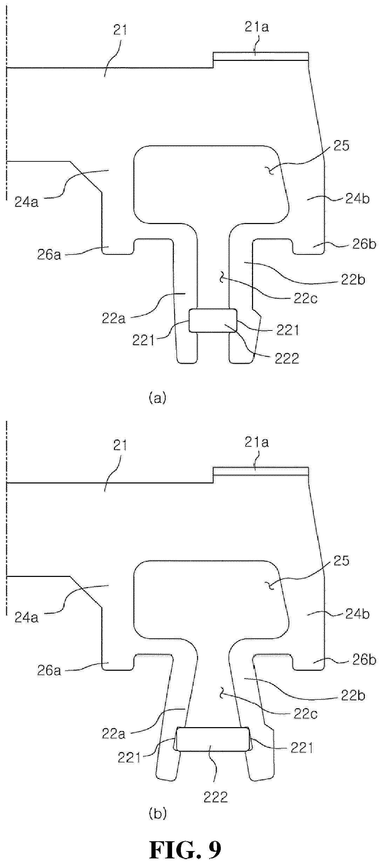

Referring to FIG. 9(A), each of the first and second fixing pins 22a, 22b may have a fixing key insert groove 221 on the inner surface at the exposed location below the printed circuit board PCB when inserted into the printed circuit board PCB.

In this instance, a fixing key 222 may be inserted in between each fixing key insert groove 221 formed in the first and second fixing pins 22a, 22b, and the fixing key 222 inserted in between the first and second fixing pins 22a, 22b acts as resistance to the separation of each fixing pin 22a, 22b in the direction opposite to the insertion direction, thereby preventing the separation of each fixing pin 22a, 22b.

Meanwhile, each fixing key insert groove 221 is preferably symmetrically formed for more balanced resistance to separation.

Additionally, referring to FIG. 9(B), the fixing key 222 may have a longer length than the length between the two fixing key insert grooves 221 provided in each of the first and second fixing pins 22a, 22b.

When the fixing key 222 has a longer length than the length between the fixing key insert grooves 221, it is possible to prevent separation more effectively by spreading the first and second fixing pins 22a, 22b.

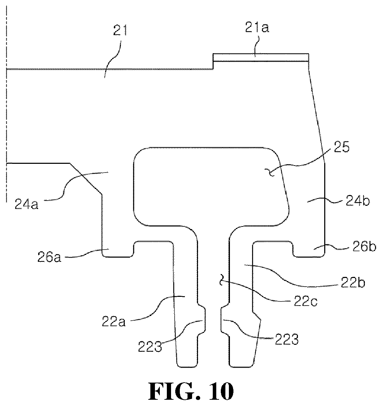

Additionally, referring to FIG. 10, the first and second fixing pins 22a, 22b may have a deflection resistance protrusion 223 which protrudes between the first fixing pin 22a and the second fixing pin 22b on the inner surface at the exposed location below the printed circuit board PCB.

The deflection resistance protrusion 223 is made of an elastically deforming material, for example, silicone or thermoplastic polyurethane (TPU), to cause elastic deformation when a predetermined force or above is applied, and thus when the first fixing pin 22a and the second fixing pin 22b are inserted into the printed circuit board PCB, the deflection resistance protrusion 223 is deformed by an operator's force such that its area becomes narrower inwards to allow the first fixing pin 22a and the second fixing pin 22b to be inserted into the printed circuit board PCB, but after insertion, when an external force as great as the operator's force does not occur, the deflection resistance protrusion 223 acts as a means for pushing each fixing pin 22a, 22b in the expansion direction, thereby preventing the separation of the first fixing pin 22a and the second fixing pin 22b.

That is, the deflection resistance protrusion 223 is a means for forming a repulsive force outwards when an external force deflecting each fixing pin 22a, 22b inwards is applied, and in this instance, preferably, the deflection resistance protrusion 223 allows deformation only to interference-fit the fixing pin 22 into the printed circuit board PCB when the operator forcibly deflects the fixing pin 22 inwards to the maximum extent, so that the fixing pin 22 is not easily deformed by any other external force than the operator's force, thereby preventing the separation of the fixing pin.

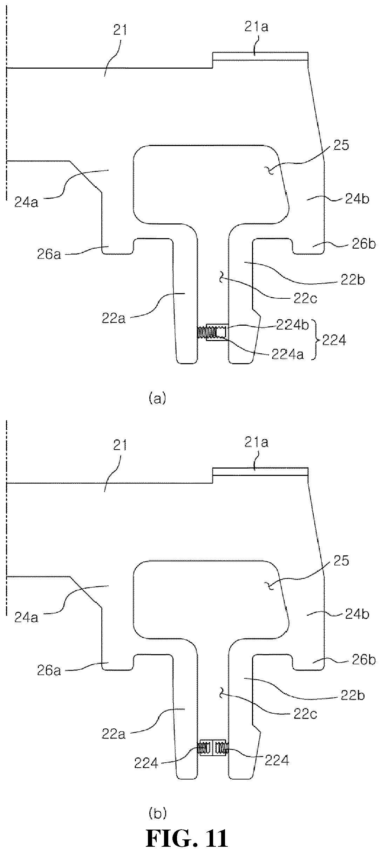

Furthermore, referring to FIGS. 11(A) and 11(B), at least one of the first fixing pin 22a or the second fixing pin 22b may include a deflection regulator 224 to regulate the extent of deflection of the fixing pin 22, and the deflection regulator 224 may include a screw protrusion 224a and a regulation member 224b.

Specifically, the screw protrusion 224a may protrude between the first and second fixing pins 22a, 22b on the inner surface at the exposed location of the fixing pin 22 below the printed circuit board PCB, and may have a screw thread on the outer surface.

Additionally, the regulation member 224b may have a screw thread which mate with the screw protrusion 224a on the inner circumferential surface to move along the screw protrusion 224a. In this instance, the regulation member 224b may decrease the extent of deflection when moving toward the fixing pin 22 on the other side, and the regulation member 224b may increase the extent of deflection when moving toward the fixing pin 22 on one side having the screw protrusion 224a along which the regulation member 224b moves.

Accordingly, it may be easy to assemble the lug, prevent separation and demount the lug in the subsequent maintenance and repair by regulating the regulation member 224b in the deflection direction of each fixing pin 22a, 22b before the insertion of each fixing pin 22a, 22b into the printed circuit board PCB, regulating the regulation member 224b in the expansion direction of each fixing pin 22a, 22b after the insertion into the printed circuit board PCB, and regulating the regulation member 224b in the deflection direction of each fixing pin 22a, 22b again when demounting.

Furthermore, the fixing pin 22 may be provided on the two sides of the lower part of the lug fixator base 21 as shown in the drawing, but this is provided for illustrative purposes and the present disclosure is not limited thereto, and a single fixing pin 22 may be provided at the center of the lug fixator base 21, and a plurality of fixing pins 22 may be provided along the length of the lug fixator base 21.

The fixing pin 22 configured as described above can be fixed without soldering, and thus soldering may be selectively performed, and in case that the fixing pin 22 is fixed without soldering, it is possible to shorten the assembly process time, facilitate the maintenance and repair and reduce the material costs, and in case that soldering is used, it is possible to solder without swell or distortion.

Although the embodiment of the present disclosure has been hereinabove described with reference to the accompanying drawings, those skilled in the art will be able to understand that the present disclosure may be embodied in other particular forms without departing from the technical spirit or essential features of the present disclosure. Therefore, the embodiments described above are not limiting but rather are exemplary in all respects.

### [Detailed Description of Main Elements]

1: Snap fit heatsink lug
10: Lug base
15: Mount groove
20: Lug fixator
21: Lug fixator base
21a: Lug fixator insert piece
22: Fixing pin
221: Fixing key insert groove
222: Fixing key
223: Deflection resistance protrusion
224: Deflection regulator
224a: Screw protrusion
224b: Regulation member
22a: First fixing pin
22b: Second fixing pin
22c: Cutout
23: Stopper
231: First inclined portion
232: Second inclined portion
232a: Pointed protrusion
233: Protruding end
234: Triangular protrusion
235: Third inclined portion
236: Fourth inclined portion
237: Pointed end
24a: First extension piece
24b: Second extension piece
25: Clearance hole
26a: First support
26b: Second support
27: Fixing cap
PCB: Printed circuit board
H: Insert hole
R: Curve

## Claims

1. A snap fit heatsink lug, comprising:
a lug base configured to have a heatsink mounted on a top thereof; and
a lug fixator disposed at two ends of the lug base and configured to fix the lug base to a printed circuit board,
wherein the lug fixator comprises:
a lug fixator base; and
a fixing pin protruding downward from a bottom of the lug fixator base and configured to be inserted into the printed circuit board, and
wherein the fixing pin comprises a first fixing pin and a second fixing pin, and at least one of the first fixing pin or the second fixing pin has a stopper at an exposed location below the printed circuit board when the fixing pin is inserted into the printed circuit board.

2. The snap fit heatsink lug according to claim 1, wherein the lug fixator further comprises a lug fixator insert piece protruding from a top of the lug fixator base toward a direction of the lug base and is insertable into the lug base, and
wherein the lug fixator is attachable to and detachable from the lug base.

3. The snap fit heatsink lug according to claim 1 or 2, wherein:
the first fixing pin is connected to a first extension piece extending downward from the lug fixator base;
the second fixing pin is connected to a second extension piece extending downward from the lug fixator base and spaced apart from a side of the first extension piece;
each of the first and second fixing pins has a shape of a right angle and extends from each extension piece such that corner surfaces face each other inwards; and
a clearance hole is formed between the first and second extension pieces and the first and second fixing pins.

4. The snap fit heatsink lug according to claim 3, wherein one of the first extension piece and the second extension piece has an inclined inner surface and the clearance hole has a trapezoidal shape.

5. The snap fit heatsink lug according to claim 3 or 4, wherein the first extension piece protrudes from an extended location of the first fixing pin to form a first support which is configured to be seated on an upper surface of the printed circuit board, and
the second extension piece protrudes from an extended location of the second fixing pin to form a second support which is configured to be seated on the upper surface of the printed circuit board.

6. The snap fit heatsink lug according to one of claims 1 to 5, wherein when only one of the first or second fixing pins has the stopper, the fixing pin which does not have the stopper among the first and second fixing pins has a decreasing width toward an insertion direction of the fixing pin.
